# EUROPÄISCHE PATENTSCHRIFT

(11) **EP 1 055 238 B1**
(45) Veröffentlichungstag und Bekanntmachung des Hinweises auf die Patenterteilung: **29.08.2001**
(21) Anmeldenummer: 98955360.7
(22) Anmeldetag: 30.09.1998
(51) Int. Cl.: G11C 29/00

(54) **TESTSCHALTUNG UND VERFAHREN ZUM PRÜFEN EINER DIGITALEN HALBLEITER-SCHALTUNGSANORDNUNG**
CIRCUIT AND METHOD FOR TESTING A DIGITAL SEMI-CONDUCTOR CIRCUIT
CIRCUIT ET PROCEDE POUR CONTROLER UN CIRCUIT NUMERIQUE A SEMI-CONDUCTEUR

(30) Priorität: 17.02.1998 DE 19806455
(43) Veröffentlichungstag der Anmeldung: 29.11.2000
(73) Patentinhaber: Infineon Technologies AG, 81669 München (DE)
(72) Erfinder: SAVIGNAC, Dominique, D-85737 Ismaning (DE); NIKUTTA, Wolfgang, D-81541 München (DE); KUND, Michael, D-81371 München (DE); TEN BROEKE, Jan, NL-8014 NP Zwolle (NL)
(74) Vertreter: Zedlitz, Peter, Dipl.-Inf.
(86) Internationale Anmeldenummer: DE9802895
(87) Internationale Veröffentlichungsnummer: WO9943004

(56) Entgegenhaltungen:
- EP-A- 0 632 468
- DE-A- 4 115 084
- US-A- 5 418 790
- US-A- 5 490 115
- US-A- 5 654 924

## Beschreibung

Die Erfindung bezieht sich auf eine monolithisch integrierte Testschaltung zum Prüfen einer auf dem selben Halbleiterchip ausgebildeten digitalen Halbleiter-Schaltungsanordnung mit einer Vielzahl von zu testenden Elementen, einer Lese- und Schreibschaltung zum Einschreiben und Auslesen eines Prüfdatenmusters in und aus den zu testenden Elementen, einer Vergleichsschaltung, sowie mit einer durch ein Aktivierungssignal aktivierbaren Mustervariierschaltung. Eine derartige Testschaltung ist aus US-A-5 418 790 bekannt.

Beim Testen der Funktion eines Halbleiterspeichers als besonders bevorzugte Ausführung einer erfindungsgemäßen Halbleiter-Schaltungsanordnung werden neben den einzelnen Daten- und Adressleitungen vor allem die Speicherzellen hinsichtlich herstellungsbedingter Fehler überprüft. Da große Mengen an Zellen bei noch im Waferverbund vorliegenden Halbleiterspeichern zu testen sind, werden diese in der Regel nicht einzeln, sondern in Gruppen zusammengefasst angesprochen. Bei einem solchen Kompressionstest werden normalerweise die Datenbits in Gruppen zusammengefasst und mit einer kleineren Anzahl von IO-Schnittstellen (IO = In-Out, d.h. Ein-Ausgabe) verbunden, als der Baustein eigentlich besitzt. In Abhängigkeit der Chiparchitektur wird bei einem Schreibzugriff über diese wenigen IO-Schnittstellen jeweils ein Datenbit auf mehreren Datenleitungen geschrieben. Bei einem Lesezugriff werden die Datenbits dieser Datenleitungen gruppenweise auf Gleichheit überprüft, und das Ergebnis dieser Prüfung wird jeweils als PASS- ("Fehlerlos") oder FAIL- ("Defekt") Information an die wenigen IO-Schnittstellen ausgegeben. Ein Nachteil dieses Vorgehens besteht darin, dass beliebige Datenmuster nicht in den Speicher geschrieben werden können, da die Datenleitungen, die zusammengefasst werden, alle eine feste Polarität haben. Da die physikalische Umgebung der Speicherzellen unterschiedlich ist und polaritätsabhängige Ausfälle bedingen kann, werden einige defekte Speicherzellen bei einem solchen "starren" Test übersehen werden. Ein solcher Test ist also nutzlos, da bereits ein einziger Speicherzellendefekt zum Ausschuss des gesamten Bauelements führen kann. Ein weiterer Nachteil dieser Vorgehensweise ist, dass die Prüfung auf Gleichheit für den Fall, dass alle zusammengefassten Datenbits "falsch" sind, ein vermeintlich "richtiges" Ergebnis liefern kann.

Aus der eingangs genannten US-A 5,418,790 ist eine Testschaltung zur Erfassung einer Interferenz für eine Halbleiterspeichervorrichtung bekannt geworden, die zur gleichzeitigen Untersuchung von Speicherzellen diese gleichzeitig mit einem einzigen für alle Speicherzellen gemeinsamen Prüf-Bit programmiert und die ermittelten, aufgrund des Prüf-Bits gespeicherten Datenwerte so zusammenfasst, dass gleichzeitig auf absolute Identität aller Datenwerte geprüft wird. Weiterhin zeigt die vorbekannte Vorrichtung vermittels eines Signals aktivierbare Logikvorrichtungen, vermittels welcher gleichzeitig das Prüf-Bit und die aus den Speicherzellen ermittelten Datenwerte vor deren Zusammenfassung invertiert werden können. Die vorbekannte Vorrichtung weist jedoch die oben genannten Nachteile auf.

Der Erfindung liegt die Aufgabe zugrunde, eine Vorrichtung zum Testen einer digitalen Halbleiter-Schaltungsanordnung, insbesondere einen Halbleiterspeicherbaustein vorzugsweise mit einer reduzierten Anzahl von Adressen und/oder von 10-Schnittstellen auf Wafer-- und auf Bausteinebene zur Verfügung zu stellen, welche konstruktiv einfacher aufgebaut ist, und bei dem gleichzeitig die Prüfschärfe gebessert ist.

Diese Aufgabe wird durch eine Testschaltung nach Anspruch 1 gelöst.

Erfindungsgemäß ist vorgesehen, dass ein Prüfdatenmusterregister zum Zwischenspeichern eines vorgesehen ist, und dass die durch ein Aktivierungssignal aktivierbare Mustervariierschaltung das Prüfdatenmuster aus dem Prüfdatenmusterregister vor dem Einschreiben in die zu testenden Elemente variiert, und dass die Vergleichsschaltung dergestalt ausgebildet ist, dass sie auf Differenz der eingeschriebenen und ausgelesenen Daten der zu testenden Elemente prüft.

Von Vorteil werden die bei jedem Zugriff angesprochenen Datenbits in Gruppen zusammengefasst, die jeweils nur Datenbits von physikalisch getrennten Wortleitungen und von physikalisch getrennten Spaltenauswahlleitungen beinhalten. Diese Gruppen werden mit einer Untermenge der IO-Schnittstellen so verbunden, dass die Adresse einer defekten Zelle eindeutig ist. Auf diese Weise kann von Vorteil der Testmodus für die Redundanz-Kalkulation benutzt werden. Eine Reduzierung des Adressraums wird durch die Zusammenfassung von Datenbits in Gruppen erreicht. Werden beispielsweise jeweils vier Datenbits in einer Gruppe zusammengefasst, so wird der Adressraum um einen Faktor 4 reduziert. Eine Reduzierung der Anzahl der IO-Schnittstellen ergibt sich automatisch: Werden beispielsweise 16 Datenbits in vier Gruppen mit jeweils vier Bits unterteilt, so ist die Anzahl der aktiven IO-Schnittstellen im Testmodus 4 anstatt 16.

Entsprechend dem JEDEC-Standard bei SDRAM-Halbleiterspeicherbausteinen kann in bevorzugter Weiterführung der Erfindung der Adress- und IO-Kompressionstestmodus durch eine Testmodussequenz eingeleitet werden, wobei neben den Adressbits, die zur Testmodus-Dekodierung notwendig sind, Prüfdatenmusterbits in dem die Testschaltung und die Halbleiter-Schaltungsanordnung beinhaltenden Baustein für die Dauer des Tests gespeichert werden. Bei einem Schreibzugriff wird die Information, die jeweils an der vorgesehenen IO-Schnittstelle anliegt, nicht direkt auf die zugehörigen Datenleitungen geschrieben, sondern mit den Prüfdatenmusterbits verknüpft. Somit können die Datenbits jeder Gruppe, die in dem zugehörigen Speicherbereich geschrieben werden, ein beliebiges Muster aufweisen, obwohl sie nur von einer IO-Schnittstelle stammen.

In einer besonders bevorzugten Ausführung der Erfindung wird das Aktivierungssignal zur Aktivierung der Mustervariierschaltung über eine bereits auf dem Halbleiterchip vorhandene Anschlussfläche ("Pad") der in der Testschaltung ausgebildeten Mustervariierschaltung zugeführt. Vorteil dieser Vorgehensweise ist, dass noch im Waferverbund die Halbleiter-Schaltungsanordnung mit variierenden Mustern geprüft werden kann, ohne dass die Prüfdatenmusterregister neu geladen werden müssen. Hierzu ist es von Vorteil, dass die digitale Halbleiter-Schaltungsanordnung in zwei Betriebsarten betreibbar ist, in einem Normalmodus, bei dem die Testschaltung deaktiviert ist und die Halbleiter-Schaltungsanordnung über die ihr zugeordneten IO-Leitungen verfügt, und in einem Testmodus, bei der die Anschlussfläche, welche bereits auf dem Halbleiterchip vorhanden und im Normalmodus für die Kopplung der digitalen Halbleiter-Schaltungsanordnung mit einem Signal vorgesehen ist, mit der Mustervariierschaltung der Testschaltung verbunden ist. Im Normalmodus ist vorzugsweisse diese Anschlussfläche von der Mustervariierschaltung entkoppelt.

In einer weiterhin bevorzugten Ausführung der Erfindung ist die Vergleichsschaitung der Testschaltung mit einer der Breite des Prüfdatenmusters entsprechenden Anzahl von Logik-Gattern ausgebildet, die bitweise die in den Halbleiterspeicher einzuschreibenden und ausgelesenden Daten vergleicht. Dieser Weiterbildung folgend ist vorteilhafterweise die Testschaltung mit einem Summengatter ausgestattet, welches mit den Logik-Gattern der Vergleichsschaltung gekoppelt ist. Das Summengatter, das vorteilhafterweise durch ein NOR-Gatter ausgebildet ist, fasst die Ergebnisse der Logik-Gatter der Vergleichsschaltung zu einem Prüf-Ergebnis zusammen. Dabei wird eine logische "Null" als Ergebnis des NOR-Gatters als "FAIL"-Signal weiterbenutzt und eine logische "Eins" als "PASS"-Signal.

In einer weiterhin bevorzugten Ausführung der Erfindung ist die Mustervariierschaltung durch eine der Breite des Prüfdatenmuster entsprechenden Anzahl von Logik-Gattern ausgebildet, welche bitweise das Prüfdatenmuster des Prüfdatenmusterregisters variieren. Hierzu kann von Vorteil die Mustervariierschaltung durch ein Aktivierungssignal aktiviert werden. Vorteilhafterweise sind die Logik-Gatter der Vergleichsschaltung und der Mustervariierschaltung durch Exklusiv-OR-Gatter ausgebildet.

In einer weiterhin bevorzugten Ausführung der Erfindung weist die Testschaltung eine Ergebnisvariierschaltung auf, welche aus einer der Breite des Prüfdatenmusters entsprechenden Anzahl von Logik-Gattern besteht, welche Logik-Gatter mit den Ausgängen der Logik-Gatter der Vergleichsschaltung verbunden sind, und denen das Summengatter an den Ausgängen nachgeschaltet ist. Bevorzugterweise sind hierbei die Logik-Gatter der Ergebnisvariierschaltung durch Exklusiv-OR-Gatter ausgebildet, die gemeinsam durch ein Ergebnisvariierungssignal aktiviert werden.

Bei einem Lesezugriff werden die Datenbits jeder Gruppe mit den variierten Prüfdatenmusterbits dergestalt verknüpft, dass die vorherige Operation rückgängig gemacht wird. Falls kein Fehler aufgetreten ist, sind nach dieser Operation alle Ergebnisbits einer Gruppe gleich, ansonsten verschieden.

Wenn alle Ergebnisbits einer Gruppe gleich dem Erwartungswert sind, wird eine PASS-Information ausgegeben. Falls mindestens ein Ergebnisbit dem Erwartungswert nicht entspricht, wird eine FAIL-Information ausgegeben. Da die Datenbitgruppen zu getrennten Speicherbereichen gehören, ist es nicht notwendig, diese Gruppen mit jeweils verschiedenen Daten zu testen. Somit genügt ein Erwartungswert für alle Gruppen; aus diesem Grunde können die Datenmusterbits für alle Gruppen gleichzeitung benutzt werden.

In einer weiterhin bevorzugten Ausführung der Erfindung wird das Aktivierungssignal der Mustervariierschaltung über eine im Testmodus nicht benutzte Ein- und Ausgabeleitung des Halbleiterspeichers zugeführt; ferner kann die Ergebnisvariierschaltung durch das Ergebnisvariierungssignal über eine ebensolche im Testmodus nicht benutzte Ein- und Ausgabeleitung des Halbleiterspeichers aktiviert werden. Dem folgend kann das FAIL- oder PASS-Signal über eine weitere im Testmodus nicht benutzte Ein- und Ausgabeleitung des Halbleiterspeichers ausgegeben werden.

Ein wesentlicher Vorteil der Erfindung im Hinblick auf einen Adress- und IO-Kompressionstestmodus liegt auch darin, Datenmusterbits einzuführen, mit denen die Datenbits, die komprimiert werden, ein beliebiges Datenmuster besitzen können, so dass der gesamte Speicher mit den selben Datenmustern geprüft werden kann, so wie dies bei einem Standardtest an sich der Fall ist. Dadurch wird erfindungsgemäß eine hohe Prüfschärfe erreicht, und es können die Vorteile einer Kompression hinsichtlich eines reduzierten Adressraumes und einer reduzierten Anzahl von IO-Schnittstellen ausgenutzt werden.

In einer weiteren vorteilhaften Ausführung der Erfindung ist eine 1-aus-4-Multiplexer-Schaltung vorgesehen, die als Ausgangssignal das Aktivierungssignal der Mustervariierschaltung liefert, und welche einen von vier Datenwerten aus einem Datenregister als Ausgangssignal liefert. In ebenso vorteilhafter Weise kann die Ergebnisvariierschaltung durch eine das Ergebnisvariierungssignal als Ausgangssignal liefernde 1-aus-4-Multiplexer-Schaltung aktiviert werden, welche einen von vier Datenwerten aus einem Ergebnisvariierungsdatenregister als Ausgangssignal liefert.

Bei einem weiteren Aspekt der Erfindung wird der Adress- und IO-Kompressions-Testmodus entsprechend dem JEDEC-Standard durch drei Testmodus-Sequenzen gesteuert. Die erste Testmodus-Sequenz schaltet den Testmodus ein, und speichert die Prüfdatenmusterbits in dem Baustein, die für die Dauer des Tests für die Erzeugung von Datenmustern in Spaltenrichtung benutzt werden. Die zweite Testmodus-Sequenz speichert Datenmusterbits im Datenregister, die bei Schreibzugriffen in Abhängigkeit von der Reihenadresse und in Verbindung mit dem Prüfdatenmusterregister für die Erzeugung von Datenmustern in Reihenrichtung benutzt werden. Bei diesen Schreibzugriffen werden die IO-Schnittstellen nicht berücksichtigt. Die dritte Testmodus-Sequenz speichert Datenmusterbits im Ergebnisvariierungsdatenregister, die bei Lesezugriffen in Abhängigkeit von der Reihenadresse und in Verbindung mit dem Prüfdatenmusterregister als Ergebnisvariierungssignal benutzt werden. Die zweite und die dritte Testmodus-Sequenz können während eines Testablaufs beliebig oft und unabhängig voneinander eingesetzt werden. Dies ist notwendig, um so genannte "March Patterns" ("fortlaufende Prüfmuster") zu ermöglichen, die sich aus Abfolgen von Lesezugriffen und von anschließenden Schreibzugriffen mit invertierten Daten für jede Speicheradresse zusammensetzen.

Bei einem Schreibzugriff wird in Abhängigkeit der Reihenadresse ein Bit aus dem Datenregister über einen Multiplexer gewählt, und mit den Prüfdatenmusterbits des Prüfdatenmusterregisters verknüpft. Dies kann z.B. mit Exklusiv-OR-Gattern ausgeführt werden. Die resultierenden Datenbits werden als Schreibdaten für jede Gruppe verwendet. Somit können die Datenbits jeder Gruppe, die in dem zugehörigen Speicherbereich geschrieben werden, ein beliebiges Muster in Spalten- und in Reihen-Richtung aufweisen.

Bei einem Lesezugriff werden die Datenbits jeder Gruppe mit den Datenmusterbits dergestalt verknüpft, dass die vorherige Operation rückgängig gemacht wird. Dies kann hier auch mit Exklusiv-OR-Gattern ausgeführt werden. Falls kein Fehler aufgetreten ist, sind nach dieser Operation alle Ergebnisbits einer Gruppe gleich, ansonsten verschieden. Die Ergebnisbits jeder Gruppe werden dann jeweils mit einem Ergebnisvariierungssignal verglichen, das in Abhängigkeit der Reihenadresse aus dem Ergebnisvariierungsdatenregister über einen Multiplexer gewählt wird. Wenn alle Ergebnisbits einer Gruppe gleich dem Ergebnisvariierungssignal sind, wird eine PASS-Information an die entsprechenden IO-Schnittstellen übergeben (z.B. logisch "1"). Falls mindestens ein Ergebnisbit dem Ergebnisvariierungssignal nicht entspricht, wird eine FAIL-Information ausgegeben (z.B. logisch "0").

Ein einfacher Testablauf setzt sich von Vorteil aus folgenden Schritten zusammen:
1- Testmodus-Sequenz 1. Der Testmodus wird eingeschaltet, und das Prüfdatenmusterregister geladen.
2- Testmodus-Sequenz 2. Das Datenregister wird geladen.
3- Schreiben eines Daten-Hintergrundes.
4- Testmodus-Sequenz 3. Das Ergebnisvariierungsdatenregister wird mit den Daten von Schritt 2 geladen.
5- Testmodus-Sequenz 2. Das Datenregister wird mit neuen Schreibdaten geladen.
6- Für jede Speicher-Adresse, Lesezugriff der Daten von Schritt 3, Schreibzugriff mit Daten von Schritt 5.
7- Testmodus-Sequenz 3. Das Ergebnisvariierungsdatenregister wird mit den Daten von Schritt 5 geladen.
8- Lesen der Daten, die bei Schritt 6 geschrieben wurden.
9- Testmodus wird abgeschaltet (entsprechend JEDEC-Standard).

Da die Datenbit-Gruppen zu unabhängigen Speicherbereichen gehören, ist es nicht notwendig, diese Gruppen mit jeweils verschiedenen Daten zu testen. Somit können das Prüfdatenmusterregister, das Datenregister und das Ergebnisvariierungsdatenregister sowie ihre zugehörigen Multiplexer für alle Gruppen gleichzeitig benutzt werden.

Zweckmäßige Weiterbildungen der Erfindung ergeben sich aus den Unteransprüchen.

Nachfolgend wird die Erfindung anhand von in der Zeichnung dargestellten Ausführungsbeispielen weiter erläutert. Im Einzelnen zeigen die schematischen Darstellungen in:
- Figur 1: eine schematische Darstellung einer Testschaltung nach einem ersten Ausführungsbeispiel der Erfindung;
- Figur 2: eine schematische Darstellung des für das Schreibverfahren notwendigen Teils einer Testschaltung mit einer IO-Schnittstelle und vier Datenkanälen nach einem zweiten Ausführungsbeispiel der Erfindung;
- Figur 3: eine schematische Darstellung des Teils der Testschaltung für das Leseverfahren mit vier Datenkanälen und einer Schnittstelle nach einem zweiten Ausführungsbeispiel der Erfindung;
- Figur 4: eine schematische Darstellung des für das Schreibverfahren notwendigen Teils einer Testschaltung mit vier Datenkanälen nach einem dritten Ausführungsbeispiel der Erfindung;
- Figur 5: eine schematische Darstellung des Teils der Testschaltung für das Leseverfahren mit vier Datenkanälen und einer Schnittstelle nach einem dritten Ausführungsbeispiel der Erfindung;
- Figur 6: eine schematische Darstellung eines Datenpfads eines digitalen Halbleiterspeichers mit x4, x8 und x16 Organisation.

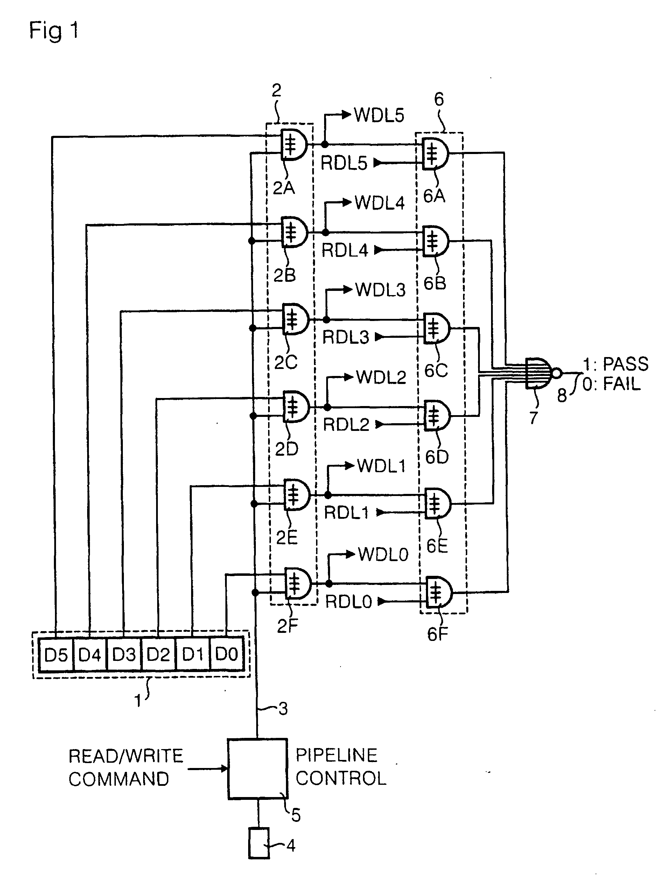

Figur 1 zeigt ein Ausführungsbeispiel einer auf einem (nicht näher dargestellten) Halbleiterchip monolithisch integrierten Testschaltung zum Prüfen der Speicherzellen eines Halbleiterspeichers mit einem Prüfdatenmusterregister 1 zum Speichern eines beispielsweise aus sechs Logikbits D0 bis D5 bestehenden Prüfdatenmusters, das durch ein im Testmodus nicht benutztes Register der Halbleiter-Schaltungsanordnung ausgebildet sein kann, und dem eine der Breite des Prüfdatenmusters entsprechende Anzahl (hier sechs) von Exklusiv-OR-Gattern 2A bis 2F nachgeschaltet ist, welche eine Mustervariierschaltung 2 bilden. Durch die Mustervariierschaltung wird das Prüfdatenmuster bitweise variiert bzw. invertiert. Die Variierung des Prüfdatenmusters wird durch Anlegen einer logischen "Eins" als Aktivierungssignal 3 an den Exklusiv-OR-Gattern 2A bis 2F initiiert. Das Aktivierungssignal 3 wird hierbei über eine auf dem Halbleiterchip ausgebildete Anschlussfläche 4, ein so genanntes "Pad", welches dabei durch das im Testmodus nicht benutzte Pad des Datenkontrolleingangs (DATACTRL) der Halbleiterschaltung ausgebildet sein kann, angelegt. Dieses Pad kann durch eine im Testmodus aktivierte Datenkontrolleinheit 5 mit der Mustervariierschaltung verbunden werden. Der Mustervariierschaltung sind Schreibdatenleitungen WDL0 bis WDL5 nachgeschaltet, über die das unveränderte oder variierte Prüfdatenmuster vermittels einer Schreib- und Leseschaltung in die geöffneten Zellen des Halbleiterspeicher eingeschrieben werden. Der Mustervariierschaltung ist des Weiteren ausgangsseitig eine Vergleichsschaltung 6 zugeordnet, die sich aus einer der Breite des Prüfdatenmusters entsprechenden Anzahl von Exklusiv-OR-Gattern 6A bis 6F zusammensetzt. Die Eingänge der Exklusiv-OR-Gatter 6A bis 6F werden dabei zum einen mit dem variierten Prüfdatenmuster, und zum anderen mit den über die Lesedatenleitungen RDL0 bis RDL5 angelegten Dateninhalten der geöffneten Zellen des Halbleiterspeichers beaufschlagt. Tritt eine Differenz zwischen den zum Einspeichern in den Halbleiterspeicher an den Schreibdatenleitungen WDL0 bis WDL5 anliegenden Pegeln und den aus dem Halbleiterspeicher ausgelesenen und an den Lesedatenleitungen RDL0 bis RDL6 anliegenden Pegeln auf, so geht der Ausgang des betroffenen Logik-Gatters auf einen logisch "Eins"-Pegel, sonst auf einen logisch "Null"-Pegel. An die Vergleichsschaltung schließt sich ein den Ausgängen der Exklusiv-OR-Gatter 6A bis 6F zugeordnetes Summengatter 7 an, das durch ein mit der Anzahl der Logik-Gatter der Vergleichsschaltung entsprechenden Anzahl von Eingängen versehenes NOR-Gatter 7 ausgebildet ist. Nur wenn alle Eingänge des NOR-Gatters 7 auf logisch "Null" liegen, also keine Differenz zwischen einem eingeschriebenen und einem ausgelesenen Datenbit besteht, wird am Ausgang 8 des NOR-Gatters 7 ein logisch "Eins"-Pegel bereitgestellt, was einem "PASS"-Signal entspricht, anderenfalls wird eine logische "Null" ausgegeben, was einem "FAIL"-Signal entspricht. Der Ausgang des Summengatters bleibt also während des gesamten Testens des Halbleiterspeichers auf einem logisch "Eins"-Pegel und geht, sobald ein Fehler auftritt, auf einen logisch "Null"-Pegel. Wird beispielsweise ein Prüfdatenmuster der Abfolge D0 bis D5 = 1,0,1,0,1,1 in das Prüfdatenmusterregister 1 eingeschrieben, so wird es vermittels der Mustervariierschaltung 2 nach deren Aktivierung in die Datenbits 0,1,0,1,0,0 invertiert und über die Schreibdatenleitungen WDL0 bis WDL5 in die Speicherzellen eingeschrieben. Die Inhalte der Speicherzellen werden über die Lesedatenleitungen RDL0 bis RDL5 mit dem variierten Prüfdatenmuster vergleichen. Angenommen eine an der Schreib- oder Lesedatenleitung WDL4 oder RDL4 liegende Speicherzelle sei defekt, so würde am Ausgang des Logik-Gatters 6B eine logisch "Eins" ausgegeben, was am Ausgang des Summengatters 7 die Ausgabe einer logischen "Null", also einem "FAIL"-Signal, zur Folge hätte.

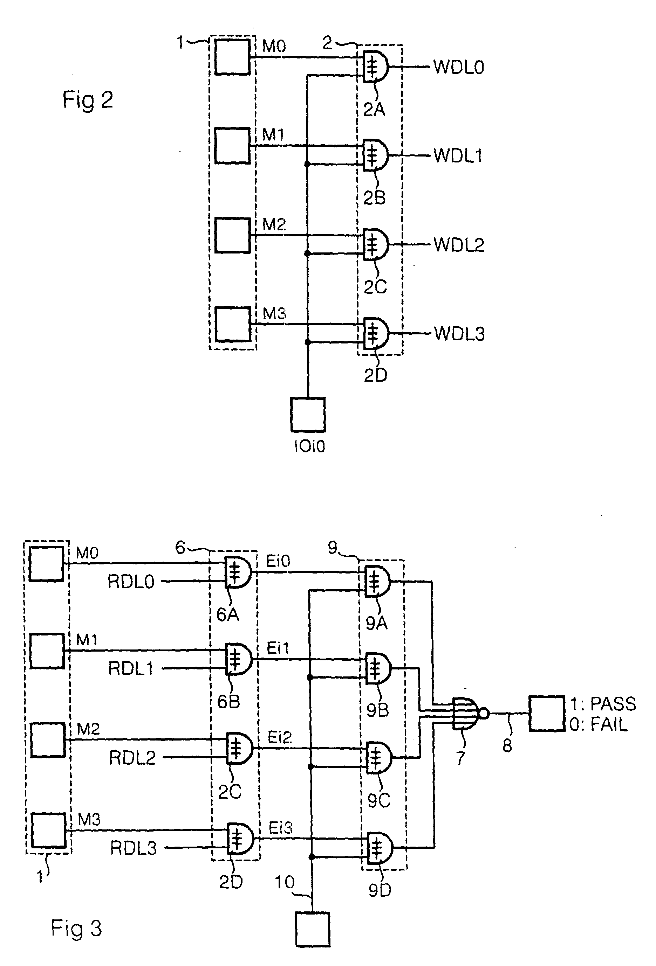

Figur 2 zeigt den in einer weiteren Ausführung der Erfindung zum Schreiben notwendigen Teil, wobei nur das Prüfdatenmusterregister 1 und die Mustervariierschaltung 2 dargestellt ist. Die Mustervariierschaltung 2 besteht im dargestellten Beispiel aus 4 Exklusiv-OR-Gattern 2A bis 2D mit jeweils 2 Eingängen. Jeweils ein Eingang jedes Logik-Gatters wird gemeinsam mit dem Aktivierungssignal über eine zugehörige IO-Schnittstelle IOi0 des Halbleiterspeichers beaufschlagt, welche IO-Schnittstelle im Testmodus sonst nicht benötigt werden würde, um den Halbleiterspeicher anzusprechen. Die jeweils zweiten Eingänge der Logik-Gatter werden jeweils mit einem Prüfdatenmusterbit M0 bis M3 aus dem Prüfdatenmusterregister 1 beaufschlagt. Die Ausgänge der Logik-Gatter sind mit den Schreibdatenleitungen WDL0 bis WDL3 des Datenspeicherblocks des Halbleiterspeichers verbunden. Wenn ein Prüfdatenmusterbit logisch 0 ist, hat das jeweilige Datenbit am Ausgang des Logik-Gatters die gleiche Polarität wie die Information der IO-Schnittstelle, ansonsten die gegenteilige Polarität. Somit können die 4 Datenbits einer Gruppe ein beliebiges Muster aufweisen, obwohl nur eine IO-Schnittstelle beim Schreiben benutzt wird.

Figur 3 zeigt den in einer weiteren Ausführung der Erfindung zum Lesen notwendigen Teil. Es ist das Prüfdatenmusterregister 1, die Vergleichsschaltung 6 und das NOR-Gatter 7 mit den schon beschriebenen Funktionsweisen dargestellt. Die Vergleichsschaltung 6 besteht im dargestellten Beispiel aus 4 Exklusiv-OR-Gattern 6A bis 6D mit jeweils 2 Eingängen, die jeweils ein Datenbit der Lesedatenleitung RDL0 bis RDL3 und ein Prüfdatenmusterbit M0 bis M3 des Prüfdatenmusterregisters 1 verknüpfen. Die Ausgänge werden nach dieser Operation alle die gleiche Polarität aufweisen, falls keine Differenz (Fehler) aufgetreten ist. Diese Ergebnisbits Ei0 bis Ei3 werden mit 4 weiteren Exklusiv-OR-Gattern 9A bis 9D einer Ergebnisvariierschaltung 9 verknüpft.

Durch die Ergebnisvariierschaltung 9 werden die Ergebnisse der Vergleichsschaltung 6 bitweise variiert, bzw. invertiert. Die Variierung der Ergebnisse wird durch Anlegen einer logischen "Eins" als Ergebnisvariierungssignal 10 an den Exklusiv-OR-Gattern 9A bis 9D initiiert. Das Ergebnisvariierungssignal 10 wird hierbei über eine Anschlussfläche, eine Registerspeicherzelle oder eine IO-Schnittstelle, welche im Testmodus zum Ansprechen des Halbleiterspeicher nicht benötigt wird, an die Ergebnisvariierschaltung 9 angelegt. Die Ausgänge der Exklusiv-OR-Gatter 9A bis 9D der Ergebnisvariierschaltung 9 werden schließlich mit dem NOR-Gatter 7 kombiniert, dessen Ausgang 8 logisch 0 wird, sobald mindestens ein angelegtes Bit logisch 1 ist (also falsch). Der Ausgang des NOR-Gatters 7 wird in diesem Ausführungsbeispiel der Erfindung mit einer im Testmodus vom Halbleiterspeicher nicht benötigten IO-Leitung verbunden, über die das Ergebnis des Testdurchlaufes nach außen ausgegeben wird. Für das Ergebnis des Summengatters (NOR-Gatter 7) gilt das gleiche, das schon in Figur 1 beschreiben wurde.

Abgesehen von der Deaktivierung der normalen Schaltungsteile und von der Aktivierung der Testschaltung, erfolgt die Steuerung des Datenpfades und der IO-Schnittstellen wie im Normalmodus. Diese Steuersignale sind der Einfachheit halber nicht gezeigt.

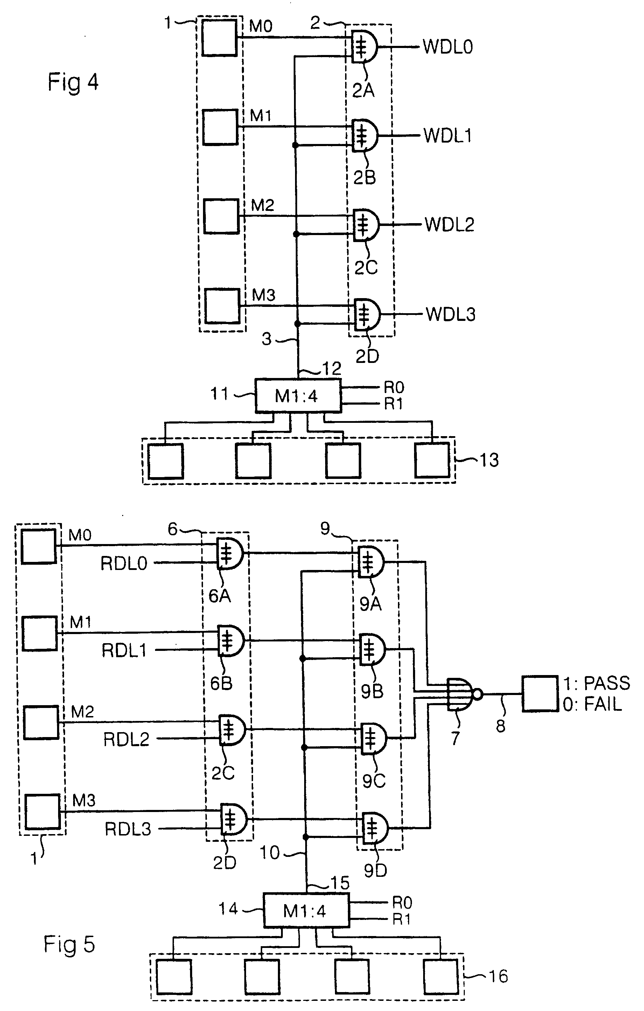

Figur 4 zeigt eine Abwandlung der in Figur 2 beschriebenen Ausführungsform der Erfindung. Hier wird das Aktivierungssignal 3 für die Aktivierung der Mustervariierschaltung 2 am Ausgang 12 einer 1-aus-4-Multiplexer-Schaltung 11 bereitgestellt. Die 1-aus-4-Multiplexer-Schaltung 11 schaltet dabei eins von vier Datenbits aus einem Datenregister 13 auf seinen Ausgang 12 auf. Die Auswahl des Datenbits des Datenregisters 13 geschieht dabei über die Reihen-Adressen R0 und R1. Somit können die Datenbits die in den Halbleiterspeicher eingeschrieben werden ein beliebiges Muster in Spalten- und in Reihen-Richtung aufweisen (hier ist die Muster-Tiefe 4x4).

Figur 5 zeigt eine Abwandlung der in Figur 3 beschriebenen Ausführungsform der Erfindung. Hier wird das Ergebnisvariierungssignal 10 für die Aktivierung der Mustervariierschaltung 2 am Ausgang 15 einer 1-aus-4-Multiplexer-Schaltung 14 bereitgestellt. Die 1-aus-4-Multiplexer-Schaltung 14 schaltet dabei eins von vier Datenbits aus einem Ergebnisvariierungsdatenregister 16 auf seinen Ausgang 15 auf. Die Auswahl des Datenbits des Ergebnisvariierungsdatenregister 16 geschieht dabei über die Reihen-Adressen R2 und R3. Die 1-aus-4-Multiplexer-Schaltung 14, das Ergebnisvariierungsdatenregister 16 und die Reihen-Adressen R2 und R3 können hierbei identisch mit denen aus Figur 4 sein. Die beiden Datenregister 13 und 16 können hierbei auch gemeinsam durch ein einziges acht Bit breites Register ausgebildet sein.

Beim Eintritt in den Testmodus, der nach dem JEDEC-Standard über so genannte "IPL-Sequenzen" initiiert wird, werden das Prüfdatenmusterregister 1 und die Datenregister 13 und/oder 16 über die Testmodussequenz 1, 2 und 3 über 4 Adressleitungen geladen, bzw. im Falle des nicht Vorhandenseins der 1-aus-4-Multiplexer-Schaltung das Aktivierungssignal 3 und das Ergebnisvariierungssignal 10 über Adress- oder 10-Leitungen bereitgestellt.

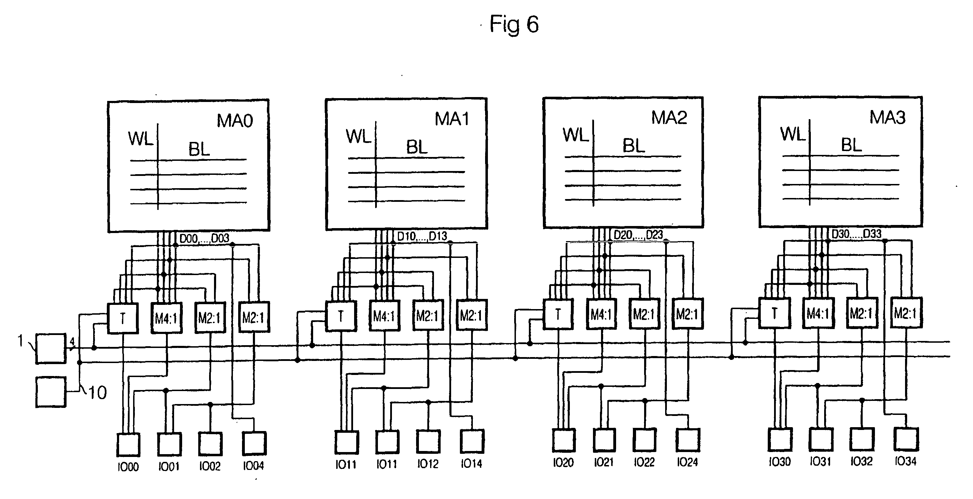

Figur 6 zeigt eine schematische Darstellung des Datenpfads eines Halbleiterspeichers in Form eines SDRAM, der eine x4, eine x8 und eine x16 Organisation erlaubt. Moderne Speicher sind üblicherweise in mehrere Blöcke unterteilt, beispielsweise in die vier Blöcke MA0, MA1, MA2, und MA3. Diese Blöcke sind nicht notwendigerweise physikalisch voneinander getrennt. Die Unterteilung wird hier so verstanden, dass bei einem Zugriff aus jedem Block eine gewisse Anzahl von Datenbits zugänglich ist, z.B. jeweils vier Datenbits D00 bis 03, D10 bis 13,..., D30 bis 33, die jeweils aus einer aktiven Wortleitung WL und mit eindeutigen Wort- und Spaltenadressen stammen. Diese Datenbits können gegebenenfalls aus mehreren Wortleitungen WL herrühren, falls bei einer Reparatur alle diese Wortleitungen gleichzeitig durch redundante Wortleitung ersetzt werden.

Bei einer x4 Organisation werden 2 Adressbits der Spaltenadresse benutzt, um eine 1 aus 4 Auswahl über Multiplexer M4:1 zu treffen. Die Ausgänge der Multiplexer M4:1 werden jeweils mit einer IO-Schnittstelle (IO00, IO01,...,IO30) verbunden. Bei einer x8 Organisation wird ein Adressbit der Spaltenadresse verwendet, um eine 1 aus 2 Auswahl über Multiplexer M2:1 zu treffen. Die Ausgänge der Multiplexer M2:1 werden mit jeweils 2 10-Schnittstellen (IO00 bis 01,..., IO30 bis 31) verbunden. Schließlich werden bei einer x16 Organisation an jedem Block vier Datenbits mit jeweils vier IO-Schnittstellen verbunden (1000 bis 03,...,IO30 bis 33). Die Zuführung dieser Datenbits zu den IO-Schnittstellen kann, wie in Figur 1 dargestellt, teilweise über die oben genannten Multiplexer geschehen, um Leitungen zu sparen.

Für jeden Block MA0, ..., MA3 ist eine erfindungsgemäße Testschaltung T vorgesehen, die zwischen den jeweils 4 Datenbits und der IO-Schnittstelle der x4 Organisation (IO00,...,IO30) geschaltet ist. Jede Testschaltung T ist über 4 Leitungen mit dem Prüfdatenmusterregister 1 (Mustertiefe 4) und über jeweils eine Leitung mit dem Ergebnisvariierungssignal 10 und dem Aktivierungssignal 3 beaufschlagbar. Das Prüfdatenmusterregister 1 wird beim Testmodus-Eintritt über 4 Adressleitungen geladen. Unabhängig von der Datenorganisation werden während des Testmodus die normalen Multiplexer und die normalen IO-Schnittstellen deaktiviert, und die Testschaltungen T mit ihren zugehörigen IO-Schnittstellen aktiviert.

Das Ergebnisvariierungssignal 10 wird bei jedem Lesezugriff z.B. über eine infolge des Einsparens von IO-Leitungen für den Testmodus (nicht alle IO-Leitungen werden benötigt) nicht benutzte Spaltenadresse angelegt, über ein internes Register zur Verfügung gestellt oder über die beschriebenen Varianten mit Hilfe von Anschlussflächen oder über die beschriebenen Multiplexer-Schaltungen.

Die dargestellte Implementierung der Erfindung benutzt dieselbe Datenbus-Struktur wie in einem normalen Modus, wobei 4 IO-Schnittstellen von 16 für die Ausgabe des Testergebnisses verwendet werden. In einer weiteren Implementierung können jedoch viermal soviele Speicherzellen als in einem normalen Modus aktiviert werden. Mit 16 Testschaltungen anstatt 4 können die Testergebnisse an 4 Gruppen von jeweils 4 IO-Schnittstellen ausgegeben werden. Die Anzahl der IO-Schnittstellen wird bei dieser Implementierung zwar nicht reduziert, der Adressraum wird aber um einen Faktor 4 weiter reduziert.

## Patentansprüche

1. Monolithisch integrierte Testschaltung zum Prüfen einer auf dem selben Halbleiterchip ausgebildeten digitalen Halbleiter-Schaltungsanordnung mit einer Vielzahl von zu testenden Elementen, einer Lese- und Schreibschaltung zum Einschreiben und Auslesen eines Prüfdatenmusters (D0 bis D5) in und aus den zu testenden Elementen, einer Vergleichsschaltung (6), sowie mit einer durch ein Aktivierungssignal (3) aktivierbaren Mustervariierschaltung (2),
**dadurch gekennzeichnet,**
dass ein Prüfdatenmusterregister (1) zum Zwischenspeichern eines Prüfdatenmusters (D0 bis D5) vorgesehen ist, und dass die durch ein Aktivierungssignal (3) aktivierbare Mustervariierschaltung (2) das Prüfdatenmuster aus dem Prüfdatenmusterregister vor dem Einschreiben in die zu testenden Elemente variiert, und dass die Vergleichsschaltung (6) dergestalt ausgebildet ist, dass sie auf Differenz der eingeschriebenen und ausgelesenen Daten der zu testenden Elemente prüft.

2. Testschaltung nach Anspruch 1,
**dadurch gekennzeichnet,**
dass das Aktivierungssignal zur Aktivierung der Mustervariierschaltung vermittels einer auf dem Halbleiterchip vorhandenen elektrisch gekoppelten Anschlussfläche ("Pad") (4) der Mustervariierschaltung zugeführt ist.

3. Testschaltung nach Anspruch 2,
**dadurch gekennzeichnet,**
dass die digitale Halbleiter-Schaltungsanordnung in zwei Betriebsarten (Normalmodus und Testmodus) betreibbar ist, wobei in der Betriebsart Testmodus die Anschlussfläche, welche bereits auf dem Halbleiterchip vorhanden und im Normalmodus für die Kopplung der digitalen Halbleiter-Schaltungsanordnung mit einem Signal vorgesehen ist, mit der Mustervariierschaltung der Testschaltung verbunden ist.

4. Testschaltung nach Anspruch 3,
**dadurch gekennzeichnet,**
dass die Anschlussfläche im Normalmodus von der Mustervariierschaltung entkoppelt ist.

5. Testschaltung nach Ansprüchen 1 bis 4,
**dadurch gekennzeichnet,**
dass die zu testende digitale Halbleiter-Schaltungsanordnung mit einer Vielzahl von zu testenden Elementen durch einen Halbleiterspeicher mit einer Vielzahl von Speicherzellen ausgebildet ist.

6. Testschaltung nach Ansprüchen 1 bis 5,
**dadurch gekennzeichnet,**
dass die Vergleichsschaltung (6) eine der Breite des Prüfdatenmusters entsprechende Anzahl von Logik-Gattern (6A bis 6F) besitzt, die bitweise die eingeschrieben und ausgelesenen Daten vergleichen.

7. Testschaltung nach Anspruch 6,
**dadurch gekennzeichnet,**
dass die Testschaltung ein mit den Logik-Gattern der Vergleichsschaltung gekoppeltes Summengatter (7) aufweist, das die Ergebnisse der Logik-Gatter der Vergleichsschaltung zu einem Ergebnis zusammenfasst.

8. Testschaltung nach Anspruch 7,
**dadurch gekennzeichnet,**
dass das Summengatter der Testschaltung durch ein NOR-Gatter ausgebildet sind.

9. Testschaltung nach Ansprüchen 1 bis 8,
**dadurch gekennzeichnet,**
dass die Mustervariierschaltung (2) eine der Breite des Prüfdatenmusters entsprechende Anzahl von Logik-Gattern (2A bis 2F) besitzt, die bitweise das Prüfdatenmuster variieren, sobald an die Mustervariierschaltung ein Aktivierungssignal (3) zur Aktivierung angelegt wird.

10. Testschaltung nach Ansprüchen 1 bis 9,
**dadurch gekennzeichnet,**
dass die Logik-Gatter der Vergleichsschaltung und der Mustervariierschaltung durch Exklusiv-OR-Gatter ausgebildet sind.

11. Testschaltung nach Ansprüchen 1 bis 10,
**dadurch gekennzeichnet,**
dass die Testschaltung eine Ergebnisvariierschaltung (9) besitzt, welche aus einer der Breite des Prüfdatenmusters entsprechenden Anzahl von Logik-Gattern (9A bis 9D) besteht, welche Logik-Gatter mit den Ausgängen der Logik-Gatter der Vergleichsschaltung (6) verbunden sind, und denen das Summengatter (7) an den Ausgängen nachgeschaltet ist.

12. Testschaltung nach Anspruch 11,
**dadurch gekennzeichnet,**
dass die Logik-Gatter der Ergebnisvariierschaltung durch Exklusiv-OR-Gatter ausgebildet sind.

13. Testschaltung nach Ansprüchen 1 bis 12,
**dadurch gekennzeichnet,**
dass die Logik-Gatter der Ergebnisvariierschaltung (9) gemeinsam durch ein Ergebnisvariierungssignal (10) aktiviert werden.

14. Testschaltung nach Ansprüchen 1 und 5 bis 13,
**dadurch gekennzeichnet,**
dass die Mustervariierschaltung über eine im Testmodus nicht benutzte Ein- und Ausgabeleitung des Halbleiterspeichers mit dem Aktivierungssignal aktiviert wird.

15. Testschaltung nach Ansprüchen 1 und 5 bis 14,
**dadurch gekennzeichnet,**
dass die Ergebnisvariierschaltung über eine im Testmodus nicht benutzte Ein- und Ausgabeleitung des Halbleiterspeichers mit dem Ergebnisvariierungssignal aktiviert wird.

16. Testschaltung nach Ansprüchen 1 und 5 bis 15,
**dadurch gekennzeichnet,**
dass die Vergleichsschaltung (6) direkt mit dem Prüfdatenmusterregister (1) verbunden ist.

17. Testschaltung nach Ansprüchen 1 und 5 bis 16,
**dadurch gekennzeichnet,**
dass das Ergebnis des Summengatters (7) über eine im Testmodus nicht benutzte Ein- und Ausgabeleitung des Halbleiterspeichers ausgegeben wird.

18. Testschaltung nach Ansprüchen 1 und 5 bis 17,
**dadurch gekennzeichnet,**
dass die Mustervariierschaltung (2) durch eine das Aktivierungssignal (3) als Ausgangssignal liefernde 1-aus-4-Multiplexer-Schaltung (11) aktiviert wird, welche einen von vier Datenwerten aus einem Datenregister (13) als Ausgangssignal liefert.

19. Testschaltung nach Ansprüchen 1 und 5 bis 18,
**dadurch gekennzeichnet,**
dass die Ergebnisvariierschaltung (9) durch eine das Ergebnisvariierungssignal (10) als Ausgangssignal liefernde 1-aus-4-Multiplexer-Schaltung (14) aktiviert wird, welche einen von vier Datenwerten aus einem Ergebnisvariierungsdatenregister (16) als Ausgangssignal liefert.

## Claims

1. Monolithically integrated test circuit for testing a digital semiconductor circuit arrangement which is formed on the same semiconductor chip and has a large number of elements to be tested, having a read and write circuit for writing and reading a test data pattern (D0 to D5) to and from the elements to be tested, having a comparison circuit (6), and having a pattern variation circuit (2) which can be activated by an activation signal (3),
**characterized**
**in that** a test data pattern register (1) is provided for temporary storage of a test data pattern (D0 to D5), and in that the pattern variation circuit (2) which can be activated by an activation signal (3) varies the test data pattern from the test data pattern register before writing into the elements to be tested, and in that the comparison circuit (6) is designed in such a way that it tests for a difference between the written and read data of the elements to be tested.

2. Test circuit according to Claim 1,
**characterized**
**in that** the activation signal for activating the pattern variation circuit is supplied by means of an electrically coupled pattern variation circuit pad (4) on the semiconductor chip.

3. Test circuit according to Claim 2,
**characterized**
**in that** the digital semiconductor circuit arrangement is operable in two modes (normal mode and test mode), wherein, in the test mode, the pad which is already present on the semiconductor chip and, in the normal mode, is intended for coupling the digital semiconductor circuit arrangement to a signal, is connected to the pattern variation circuit of the test circuit.

4. Test circuit according to Claim 3,
**characterized**
**in that**, in the normal mode, the pad is decoupled from the pattern variation circuit.

5. Test circuit according to Claims 1 to 4,
**characterized**
**in that** the digital semiconductor circuit arrangement to be tested and having a large number of elements to be tested is formed by a semiconductor memory having a large number of memory cells.

6. Test circuit according to Claims 1 to 5,
**characterized**
**in that** the comparison circuit (6) has a number of logic gates (6A to 6F) corresponding to the width of the test data pattern, which gates compare the written and read data bit-by-bit.

7. Test circuit according to Claim 6,
**characterized**
**in that** the test circuit has an addition gate (7) which is coupled to the logic gates of the comparison circuit and combines the results of the logic gates of the comparison circuit to form a result.

8. Test circuit according to Claim 7,
**characterized**
**in that** the addition gate of the test circuit is formed by a NOR gate.

9. Test circuit according to Claims 1 to 8,
**characterized**
**in that** the pattern variation circuit (2) has a number of logic gates (2A to 2F) corresponding to the width of the test data pattern, which gates vary the test data pattern bit-by-bit as soon as an activation signal (3) for activation is applied to the pattern variation circuit.

10. Test circuit according to Claims 1 to 9,
**characterized**
**in that** the logic gates of the comparison circuit and in the pattern variation circuit are formed by exclusive-OR gates.

11. Test circuit according to Claims 1 to 10,
**characterized**
**in that** the test circuit has a result variation circuit (9) which comprises a number of logic gates (9A to 9D) corresponding to the width of the test data pattern, which logic gates are connected to the outputs of the logic gates in the comparison circuit (6), and downstream from which the addition gate (7) is connected to the outputs.

12. Test circuit according to Claim 11,
**characterized**
**in that** the logic gates in the result variation circuit are formed by exclusive-OR gates.

13. Test circuit according to Claims 1 to 12,
**characterized**
**in that** the logic gates in the result variation circuit (9) are activated jointly by a result variation signal (10).

14. Test circuit according to Claims 1 and 5 to 13,
**characterized**
**in that** the pattern variation circuit is activated by the activation signal via a semiconductor memory input and output line which is not used in the test mode.

15. Test circuit according to Claims 1 and 5 to 14,
**characterized**
**in that** the result variation circuit is activated by the result variation signal via a semiconductor memory input and output line which is not used in the test mode.

16. Test circuit according to Claims 1 and 5 to 15,
**characterized**
**in that** the comparison circuit (6) is connected directly to the test data pattern register (1).

17. Test circuit according to Claims 1 and 5 to 16,
**characterized**
**in that** the result of the addition gate (7) is output via a semiconductor memory input and output line which is not used in the test mode.

18. Test circuit according to Claims 1 and 5 to 17,
**characterized**
**in that** the pattern variation circuit (2) is activated by a 1-from-4 multiplexer circuit (11) whose output signal is the activation signal (3) and which supplies one of four data values from a data register (13) as the output signal.

19. Test circuit according to Claims 1 and 5 to 18,
**characterized**
**in that** the result variation circuit (9) is activated by a 1-from-4 multiplexer circuit (14) whose output. signal is the result variation signal (10) and which supplies one of four data values from a result variation data register (16) as the output signal.

## Revendications

1. Circuit de test intégré monolithique pour tester un circuit à semi-conducteurs numérique constitué sur la même puce à semi-conducteurs et comportant de nombreux éléments à tester, un circuit de lecture et d'écriture pour écrire et lire un modèle de données de test (D0 à D5) dans les éléments à tester, un circuit comparateur (6), ainsi qu'un circuit de modification dé modèle (2) pouvant être activé par un signal d'activation (3),
**caractérisé par le fait qu**'un registre de modèle de données de test (1) est prévu pour mémoriser temporairement un modèle de données de test (D0 à D5), que le circuit de modification de modèle (2) pouvant être activé par un signal d'activation (3) modifie le modèle de données de test issu du registre de modèle de données de test avant l'écriture dans les éléments à tester et que le circuit comparateur (6) est conçu de manière à tester une éventuelle différence entre données écrites et données lues des éléments à tester.

2. Circuit de test selon la revendication 1,
**caractérisé par le fait que** le signal d'activation destiné à l'activation du circuit de modification de modèle est envoyé au circuit de modification de modèle au moyen d'une surface de connexion ("Pad") (4) présente sur la puce à semi-conducteurs et couplée électriquement.

3. Circuit de test selon la revendication 2,
**caractérisé par le fait que** le circuit à semi-conducteurs numérique peut fonctionner selon deux types d'exploitation (mode normal et mode de test), la surface de connexion qui est déjà présente sur la puce à semi-conducteurs et qui est prévue en mode normal pour le couplage du circuit à semi-conducteurs numérique avec un signal étant reliée dans le type d'exploitation mode de test au circuit de modification de modèle du circuit de test.

4. Circuit de test selon la revendication 3,
**caractérisé par le fait que** la surface de connexion est découplée du circuit de modification de modèle en mode normal.

5. Circuit de test selon les revendications 1 à 4,
**caractérisé par le fait que** le circuit à semi-conducteurs numérique à tester comportant de nombreux éléments à tester est formé par une mémoire à semi-conducteurs comportant de nombreuses cellules de mémoire.

6. Circuit de test selon les revendications 1 à 5,
**caractérisé par le fait que** le circuit comparateur (6) a un nombre, correspondant à la largeur du modèle de données de test, de portes logiques (6A à 6F) qui comparent bit à bit les données écrites et les données lues.

7. Circuit de test selon la revendication 6,
**caractérisé par le fait que** le circuit de test comporte une porte de cumul (7) qui est couplée aux portes logiques du circuit comparateur et qui réunit les résultats dès portés logiques du circuit comparateur en un résultat.

8. Circuit de test selon la revendication 7,
**caractérisé par le fait que** la porte de cumul du circuit de test est formée par une porte NOR.

9. Circuit de test selon les revendications 1 à 8,
**caractérisé par le fait que** le circuit de modification de modèle (2) a un nombre, correspondant à la largeur du modèle de données de test, de portes logiques (2A à 2F) qui modifient bit à bit le modèle de données de test dès qu'un signal d'activation (3) destiné à l'activation est appliqué au circuit de modification de modèle.

10. Circuit de test selon les revendications 1 à 9,
**caractérisé par le fait que** les portes logiques du circuit comparateur et du circuit de modification de modèle sont formées par des portes OU-EXCLUSIF.

11. Circuit de test selon les revendications 1 à 10,
**caractérisé par le fait que** le circuit de test comporte un circuit de modification de résultat (9) qui est constitué d'un nombre, correspondant à la largeur du modèle de données de test, de portes logiques (9A à 9D) qui sont reliées aux sorties des portes logiques du circuit comparateur (6) et du côté aval desquelles la porte de cumul (7) est branchée aux sorties.

12. Circuit de test selon la revendication 11,
**caractérisé par le fait que** les portes logiques du circuit de modification de résultat sont formées par des portes OU-EXCLUSIF.

13. Circuit de test selon les revendications 1 à 12,
**caractérisé par le fait que** les portes logiques du circuit de modification de résultat (9) sont activées en commun par un signal de modification de résultat (10).

14. Circuit de test selon les revendications 1 et 5 à 13,
**caractérisé par le fait que** le circuit de modification de modèle est activé avec le signal d'activation par l'intermédiaire d'une ligne d'entrée et de sortie, non utilisée en mode de test, de la mémoire à semi-conducteurs.

15. Circuit de test selon les revendications 1 et 5 à 14,
**caractérisé par le fait que** le circuit de modification de résultat est activé par le signal d'activation de résultat par l'intermédiaire d'une ligne d'entrée et de sortie, non utilisée dans le mode de test, de la mémoire à semi-conducteurs.

16. Circuit de test selon les revendications 1 et 5 à 15,
**caractérisé par le fait que** le circuit comparateur (6) est relié directement au registre de modèle de données de test (1).

17. Circuit de test selon les revendications 1 et 5 à 16,
**caractérisé par le fait que** le résultat de la porte de cumul (7) est sorti par l'intermédiaire d'une ligne d'entrée et de sortie, non utilisée dans le mode de test, de la mémoire à semi-conducteurs.

18. Circuit de test selon les revendications 1 et 5 à 17,
**caractérisé par le fait que** le circuit de modification de modèle (2) est activé par un circuit multiplexeur 1 parmi 4 (11) qui fournit comme signal de sortie le signal d'activation (3) et qui fournit comme signal de sortie l'une des quatre valeurs de données issues d'un registre de données (13).

19. Circuit de test selon les revendications 1 et 5 à 18,
**caractérisé par le fait que** le circuit de modification de résultat (9) est activé par un circuit multiplexeur 1 parmi 4 (14) qui fournit comme signal de sortie le signal de modification de résultat (10) et qui fournit comme signal de sortie l'une des quatre valeurs de données issues d'un registre de données de modification de résultat (16).
